# FASCICULE DE BREVET EUROPEEN

(11) **EP 0 900 859 B1**
(45) Date de publication et mention de la délivrance du brevet: **05.03.2003**
(21) Numéro de dépôt: 98401705.3
(22) Date de dépôt: 06.07.1998
(51) Int. Cl.: C23C 16/40, C23C 16/02, H01L 21/316

(54) **Procédé de dépôt d'une couche diélectric de Ta205**
Verfahren zur Ablagerung einer dielektrischen Ta2O5-Schicht
Process for deposition of a dielectric Ta2O5 layer

(30) Priorité: 15.07.1997 FR 9708955
(43) Date de publication de la demande: 10.03.1999
(73) Titulaire: FRANCE TELECOM, 75015 Paris (FR)
(72) Inventeur: Berenguer, Marc, 38420 Revel (FR); Devine, Roderick, 38950 Saint-Martin-le Vinoux (FR)
(74) Mandataire: Casalonga, Axel

(56) Documents cités:
- US-A- 4 891 684
- SUN S C ET AL: "CHARACTERIZATION OF RAPID THERMAL ANNEALING OF LPCVD TA2O5 FILMS INNITRIC OXIDE AMBIENT" MEETING ABSTRACTS, vol. 95/2, 1 janvier 1995, page 870/871 XP000553893
- PATENT ABSTRACTS OF JAPAN vol. 008, no. 190 (E-263), 31 août 1984 & JP 59 078553 A (HITACHI SEISAKUSHO KK), 7 mai 1984

## Description

La présente invention concerne de manière générale un procédé de dépôt d'une couche diélectrique telle que le Ta₂O₅ sur un substrat susceptible d'être nitruré.

L'augmentation de la densité d'intégration et de la rapidité des circuits électroniques conduit à une réduction régulière de la dimension des composants, tels que les transistors élémentaires. De ce fait, l'évolution des technologies de fabrication est en particulier caractérisée par une diminution des épaisseurs de certains matériaux utilisés, en particulier le matériau diélectrique de grille des transistors, permettant une plus grande intégration.

Pour cette raison, on a envisagé de remplacer le matériau diélectrique classiquement utilisé, SiO₂, par des matériaux plus performants. Un des matériaux retenus est le pentoxyde de tantale Ta₂O_{5,}, car il présente une plus grande permittivité électrique que l'oxyde de silicium.

Le dépôt de Ta₂O₅ est classiquement effectué par dépôt chimique en phase vapeur (CVD) ou dépôt chimique en phase vapeur assisté par plasma (PECVD). La qualité du dépôt dépend de l'état de surface du substrat et en particulier de son énergie de surface qui doit être autant que possible prédéterminée, constante et reproductible. En outre, il est nécessaire de procéder à un traitement thermique de la couche déposée pour remédier aux défauts induits pendant la fabrication. Ces traitements généralement oxydants peuvent par diffusion d'espèces à travers le diélectrique diminuer fortement la permittivité électrique de la couche déposée.

La présente invention a donc pour objet un procédé de dépôt d'une couche diélectrique de Ta₂O₅ qui remédie aux inconvénients des procédés connus.

Selon l'invention, on a mis au point un procédé de dépôt d'une couche diélectrique de Ta₂O₅ sur un substrat susceptible d'être nitruré qui comprend les étapes suivantes :
- prétraitement d'une surface du substrat au moyen d'un plasma gazeux froid à basse ou moyenne pression pour nettoyer ladite surface;
- croissance à partir de ladite surface nettoyée du substrat d'une couche barrière de nitrure au moyen d'un plasma gazeux froid d'un mélange N₂/H₂ à basse ou moyenne pression; et
- le dépôt sur la couche barrière de nitrure d'une couche diélectrique de Ta₂O₅ par dépôt chimique en phase vapeur (CVD) ou dépôt chimique en phase vapeur assisté par plasma (PECVD).

Le terme plasma froid utilisé dans cette demande de brevet désigne des plasmas hors d'équilibre avec peu de transfert d'énergie par collisions atomes-électrons et comportant donc des atomes (ou des radicaux) froids par opposition aux plasmas chauds (plasmas stellaires ou plasmas de fusion thermonucléaire). Ces plasmas peu collisionnels et dont la température électronique est de l'ordre de quelques électrons-volts sont de plus hors de l'équilibre thermodynamique local. Les plasmas utilisés pour les différents traitements en microélectronique (gravure, dépôt, nettoyage, ...) et même plus généralement pour les traitements de surface des matériaux, sont toujours du type "plasma froid" tel que défini ci-dessus.

La notation nₑ > 10¹¹ cm⁻³ se rapporte uniquement à la densité électronique. Mais le paramètre nₑ est bien évidemment déterminant pour la création d'espèces actives dans le plasma. Le critère nₑ > 10¹¹ cm⁻³ correspond donc à un plasma de densité très élevée conduisant à la production d'une concentration importante de ces espèces permettant un traitement de surface efficace avec une durée très réduite. Toutefois, la valeur de nₑ n'est en fait pas très critique et il est parfaitement possible de réaliser de tels traitements avec des plasmas de densité électronique plus faible nₑ << 10¹¹ cm⁻³ si l'on s'autorise des procédés d'une durée plus longue (par exemple traitement collectif des échantillons dans un réacteur à fournée).

Le domaine de pression de fonctionnement des procédés de traitement plasma est directement lié au type de réacteur (source) plasma utilisé. Plusieurs types de réacteurs fonctionnant avec des gammes de pressions différentes peuvent convenir pour cette application. Ces gammes de pression ne diffèrent pas notablement de celles des procédés (dépôt, gravure) pour lesquels les réacteurs sont habituellement conçus. Un exemple de réacteur fonctionnant à "moyenne pression" (50-1000 mTorr) est donné par le type diode RF (dépôt d'oxyde PECVD). Les sources de plasma de génération plus récente (ECR, DECR, couplage inductif, hélicon, ...) utilisées aussi bien pour le dépôt que pour la gravure constituent des exemples de systèmes fonctionnant à "basse pression" (typiquement 0,5-10 mTorr).

Les substrats auxquels s'applique le procédé de l'invention, sont tous substrats constitués d'un matériau susceptible d'être nitruré, c'est-à-dire apte à former un nitrure, tels que des matériaux semi-conducteurs comme Si, SiO₂ et Geₓ Si₁₋ₓ (O<x≤1), des matériaux conducteurs comme les métaux, par exemple Ti, W, Al et Cu, ou encore des polymères à groupes polaires.

Les matériaux préférés pour les substrats utiles dans le procédé selon l'invention, sont les matériaux semi-conducteurs et en particulier Si, SiO₂ et Geₓ Si₁₋ₓ.

La première étape du procédé selon l'invention est une étape de prétraitement d'une surface du substrat au moyen d'un plasma gazeux froid à basse ou moyenne pression pour nettoyer la surface de ses impuretés, par l'exemple l'oxyde natif dans le cas d'un substrat de silicium, sans induire d'irrégularités de surface notables. Les plasmas gazeux utilisés de préférence sont des plasmas d'hydrogène, de mélanges d'hydrogène et d'argon, et d'oxygène. Les plasmas particulièrement recommandés sont les plasmas d'hydrogène. On utilise les plasmas d'oxygène pour le nettoyage des substrats comportant une surface hydrocarbonée ou fortement souillée, par exemple par des huiles.

Les prétraitements de nettoyage des surfaces de substrats par plasma sont connus en eux-mêmes.

De préférence, cette étape de prétraitement s'effectue à une température inférieure à 300°C, et mieux encore à la température ambiante. La pression est généralement comprise entre 10⁻⁴ et 1 Torr, de préférence entre 10⁻³ et 10⁻² Torr.

La densité du plasma nₑ est de 10¹⁰cm⁻³ ou plus et de préférence ≥ 10¹¹ cm⁻³, afin de réduire la durée du prétraitement.

Cette étape de prétraitement a généralement une durée comprise entre 1 seconde à 1 minute, et est de préférence de l'ordre de 30 secondes, pour éviter la formation de rugosités importantes dans la surface.

Ce prétraitement par plasma doit fournir une énergie de bombardement ionique faible pour ne pas créer de défauts dans la surface traitée. C'est pourquoi on effectue de préférence le prétraitement avec une différence entre le potentiel du plasma et le potentiel flottant, Vₚ -V_{f} < 20 V.

La deuxième étape du procédé de l'invention consiste en une étape de croissance d'une couche barrière de nitrure à partir de la surface prétraitée du substrat, dans laquelle le matériau du substrat participe à la formation de la couche barrière de nitrure.

Cette étape de croissance s'effectue en utilisant un plasma froid à basse ou moyenne pression, d'un mélange N₂/H₂, de préférence un plasma haute densité. Cette étape de croissance de la couche barrière de nitrure s'effectue généralement à une température inférieure à 300°C, de préférence à la température ambiante. Les débits d'azote et d'hydrogène sont généralement compris dans un rapport N₂/H₂ d'environ 1.5/1 à 4/1, de préférence de l'ordre de 2/1.

La durée de cette étape de croissance est généralement comprise entre 5 à 15 minutes, de préférence 7 à 10 minutes.

Ainsi, dans le cas d'un substrat de silicium, on forme dans cette étape de croissance une couche barrière de nitrure de silicium Si₃N₄.

La croissance de la couche de nitrure de silicium sature naturellement à une épaisseur de 2 nm (mesurée par ellipsométrie, indice n fixé à 2) par arrêt de diffusion des espèces réactives à travers la couche. Cela est dû essentiellement au fait qu'on utilise des plasmas à faible énergie de bombardement ionique (Vₚ-V_{f} < 20 V) et avec peu d'assistance thermique.

La couche barrière de nitrure qui modifie les liaisons de surface du substrat entraîne une augmentation de la partie polaire de l'énergie de surface. Cette couche barrière de nitrure présente une énergie de surface stabilisée, uniforme et reproductible, ce qui garantit un contrôle du dépôt ultérieur de Ta₂O₅ et améliore l'adhérence du dépôt de Ta₂O₅. Enfin, cette couche barrière de nitrure empêche l'oxydation des couches sous-jacentes lors des traitements ultérieurs, tels que les recuits, par exemple après dépôt de la couche de Ta₂O₅.

Dans le cas d'une couche barrière de Si₃N₄, on a caractérisé cette couche en mesurant son épaisseur par ellipsométrie.

On a également mesuré les parties apolaire et polaire de l'énergie de surface par la méthode consistant à mesurer l'angle de contact d'une goutte de liquide avec la surface de la couche barrière. En mesurant l'angle de contact d'une goutte de diiodométhane, on détermine la composante apolaire de l'énergie de surface dont la valeur est directement reliée à la nature chimique de la surface. La mesure de l'angle de contact d'une goutte d'eau caractérise la composante polaire de l'énergie de surface.

Un appareil du commerce pour la mesure des angles de contact est l'appareil G2/G40 de la Société KRÜSS.

### EXEMPLE

On a réalisé dans un réacteur DECR avec un confinement magnétique un dépôt de Ta₂O₅ sur un substrat de silicium en utilisant le procédé de l'invention.

Les conditions de traitement et de dépôt sont indiquées dans le tableau ci-dessous.

| | Débit H₂ (cm³/minute) | | Temps (minutes) | | P (microonde) (W) |
|---|---|---|---|---|---|
| Prétraitement | 25 | | 1,5 | | 750 |

| | Débit H₂ (cm³/minute) | Débit N₂ (cm³/minute) | Temps (minutes) | | P (microonde) (W) |
|---|---|---|---|---|---|
| Croissance de la couche barrière de Si₃N₄ | 10 | 18,8 | 10 | | 750 |

| | Pression(H₂+O₂) (mTorr) | Pression(H₂+O₂ + TaF₅) (mToor) | Temps (minute) | Température substrat (°C) | P(microonde) (W) |
|---|---|---|---|---|---|
| Dépôt PECVD de la couche de Ta₂O₅ | 2,120 | 2,180 | 10 | 50 | 750 |

On utilise comme source TaF₅ solide et les étapes de prétraitement et de croissance sont mises en oeuvre à la température ambiante.

La couche de Ta₂O₅ obtenue a une épaisseur de 38,8 nm et un indice de 2,14.
- Caractérisation de la couche barrière de Si₃N₄.

On mesure pour cette couche une épaisseur équivalente de 2 nm à un indice fixé de 2 car l'épaisseur est trop faible pour que l'appareil de mesure en détermine l'indice.

On mesure les composantes apolaire et polaire de l'énergie de surface par la méthode des gouttes et on compare les résultats obtenus avec ceux d'une couche de nitrure de silicium de référence.

Les résultats sont donnés dans le tableau ci-dessous.

| | Référence | Echantillon |
|---|---|---|
| Angle diiodométhane | 34 | 34 |
| | | |
| Angle H₂O | 38 | 10 |

La valeur de l'angle de contact en diiodométhane garantit que la couche barrière est bien du nitrure de silicium.

La valeur de l'angle de contact en eau, caractérisant la composante polaire de l'énergie de surface, montre que cette valeur est très élevée et par conséquent le dépôt de Ta₂O₅ aura une grande affinité de liaison avec la couche barrière, créant ainsi un assemblage de bonne cohésion. En outre, ces valeurs garantissent une reproductibilité du dépôt.

On a confirmé par spectroscopies AUGER et XPS que la couche barrière était bien un composé stoechiométrique de silicium et d'azote (Si₃N₄).

Pour confirmer que cette couche forme une barrière effective, on a soumis à un traitement thermique sous atmosphère d'oxygène un échantillon comportant sur un substrat de silicium une couche barrière selon le procédé de l'invention et une couche de Ta₂O₅ et un échantillon témoin ne comportant pas de couche barrière. Après 70 minutes à 900°C sous atmosphère d'oxygène à la pression atmosphérique, on obtenait une couche de 20 nm de SiO₂ sur l'échantillon témoin et aucune modification sur l'échantillon comportant la couche barrière selon l'invention.

L'ensemble de l'échantillon (couche barrière de nitrure + couche diélectrique) a été caractérisé par spectroscopie AUGER et par des mesures électriques classiques de capacité (C(V)) et d'intensité (I(V)).

Le procédé de l'invention est particulièrement adapté pour la fabrication des transistors en remplacement des étapes classiques de réalisation de l'oxyde de silicium constituant la grille des transistors.

Le procédé de l'invention peut également être avantageusement utilisé pour la fabrication des mémoires non volatiles. Dans ce cas, les étapes de prétraitement et de croissance auront pour effet de créer une couche de nitrure de silicium sur une grille flottante en silicium polycristallin sur un oxyde de silicium, et l'étape de dépôt Ta₂O₅ formera une couche diélectrique. Cette couche fortement diélectrique aura pour effet d'abaisser le potentiel électrique nécessaire pour écrire dans la mémoire. Quant à la couche de Si₃N₄, elle assurera une meilleure retenue des informations stockées en diminuant les fuites des charges électriques à travers la couche de Ta₂O₅.

Enfin, le procédé selon l'invention est également avantageusement utilisé pour la fabrication des capacités de mémoires des structures DRAM, des capacités diélectriques élevées des circuits intégrés telles que des condensateurs et capacités de découplage d'alimentation ou de filtrage.

## Revendications

1. Procédé de dépôt d'une couche diélectrique de Ta₂O₅ sur un substrat susceptible d'être nitruré, **caractérisé en ce qu'**il comprend les étapes suivantes :
a) prétraitement d'une surface du substrat au moyen d'un plasma gazeux froid à basse ou moyenne pression pour nettoyer ladite surface;
b) croissance à partir de ladite surface nettoyée du substrat d'une couche barrière de nitrure au moyen d'un plasma gazeux froid d'un mélange N₂/H₂ à basse ou moyenne pression; et
c) le dépôt sur la couche barrière de nitrure d'une couche diélectrique de Ta₂O₅ par dépôt chimique en phase vapeur (CVD) ou dépôt chimique en phase vapeur assisté par plasma (PECVD).

2. Procédé selon la revendication 1, **caractérisé en ce que** le plasma gazeux de l'étape de prétraitement est un plasma gazeux d'hydrogène, d'un mélange d'hydrogène et d'argon ou d'oxygène.

3. Procédé selon la revendication 1 ou 2, **caractérisé en ce que** l'étape de prétraitement (a) s'effectue à une température inférieure à 300°C, de préférence à la température ambiante.

4. Procédé selon l'une quelconque des revendications 1 à 3, **caractérisé en ce que** l'étape de croissance (b) s'effectue à une température inférieure à 300°C, de préférence à la température ambiante.

5. Procédé selon l'une quelconque des revendications 1 à 4, **caractérisé en ce que** le substrat susceptible d'être nitruré est constitué d'un matériau semi-conducteur, conducteur ou d'un polymère à groupes polaires.

6. Procédé selon la revendication 5, **caractérisé en ce que** le substrat est choisi parmi le silicium, l'oxyde de silicium (SiO₂), les mélanges germanium-silicium GeₓSi₁₋ₓ où O<x≤1, le titane, le tungstène, l'aluminium et le cuivre.

7. Procédé selon la revendication 6, **caractérisé en ce que** le substrat est du silicium ou de l'oxyde de silicium et la couche barrière une couche de nitrure de silicium Si₃N₄.

8. Procédé selon la revendication 7, **caractérisé en ce que** la couche diélectrique de Ta₂O₅ constitue la couche diélectrique de la grille d'un transistor, d'une structure de mémoire non volatile, d'une capacité d'une mémoire DRAM, ou d'une capacité de découplage ou de filtrage d'un circuit intégré.

## Patentansprüche

1. Verfahren zur Ablagerung einer dielektrischen Schicht von Ta2O₅ auf einem Substrat, das in der Lage ist, nitriert zu werden, **dadurch gekennzeichnet, daß** es die folgenden Stufen umfaßt:
a) Vorbehandlung einer Oberfläche des Substrates mittels eines kalten Gasplasmas mit niedrigem oder mittlerem Druck zum Reinigen dieser Oberfläche,
b) Aufwachsen ausgehend von dieser gereinigten Oberfläche des Substrates einer Sperrschicht von Nitrid mittels eines kalten Gasplasmas aus einem Gemisch N₂/H₂ bei niedrigem oder mittlerem Druck, und
c) Ablagerung auf der Nitrid-Sperrschicht einer dielektrischen Ta₂O₅-Schicht durch chemische Abscheidung aus der Dampfphase (CVD) oder durch Plasma unterstützte chemische Abscheidung aus der Dampfphase.

2. Verfahren nach Anspruch 1, **dadurch gekennzeichnet, daß** das Gasplasma der Stufe der Vorbehandlung ein Gasplasma von Wasserstoff, einem Gemisch von Wasserstoff und Argon oder Sauerstoff ist.

3. Verfahren nach Anspruch 1 oder 2, **dadurch gekennzeichnet, daß** die Stufe der Vorbehandlung (a) bei einer Temperatur unterhalb 300°C, bevorzugt bei Umgebungstemperatur, durchgeführt wird.

4. Verfahren nach einem der Ansprüche 1 bis 3, **dadurch gekennzeichnet, daß** die Stufe des Aufwachsens (b) bei einer Temperatur unterhalb 300°C, bevorzugt bei Umgebungstemperatur, durchgeführt wird.

5. Verfahren nach einem der Ansprüche 1 bis 4, **dadurch gekennzeichnet, daß** das zur Nitrierung fähige Substrat durch ein Halbleitermaterial, Leitermaterial oder ein Polymeres mit polaren Gruppen gebildet wird.

6. Verfahren nach Anspruch 5, **dadurch gekennzeichnet, daß** das Substrat unter Silizium, Siliziumoxid (SiO₂), den Gemischen Germanium-Silizium GeₓSi₁₋ₓ, worin 0 < x ≤ 1 ist, Titan, Wolfram, Aluminium und Kupfer ausgewählt wird.

7. Verfahren nach Anspruch 6, **dadurch gekennzeichnet, daß** das Substrat Silizium oder Siliziumoxid ist und die Sperrschicht eine Schicht von Siliziumnitrid, Si₃N₄, ist.

8. Verfahren nach Anspruch 7, **dadurch gekennzeichnet, daß** die dielektrische Schicht aus Ta₂O₅ die dielektrische Gitterschicht eines Transistors mit einer dauerhaften Speicherstruktur mit einer Kapazität eines DRAM-Speichers oder einer Fähigkeit zum Entkoppeln oder zur Filterung einer integrierten Schaltung bildet.

## Claims

1. Process for depositing a Ta₂O₅ dielectric layer on a substrate capable of being nitrided, **characterized in that** it comprises the following steps:
a) pretreatment of a surface of the substrate by means of a cold gas plasma at low or medium pressure in order to clean the said surface;
b) growth, from the said cleaned surface of the substrate, of a nitride barrier layer by means of a cold gas plasma made up of an N₂/H₂ mixture at low or medium pressure; and
c) deposition, on the nitride barrier layer, of a Ta₂O₅ dielectric layer by chemical vapour deposition (CVD) or plasma enhanced chemical vapour deposition (PECVD).

2. Process according to Claim 1, **characterized in that** the gas plasma for the pretreatment step is a gas plasma made up of hydrogen, a mixture of hydrogen and argon or oxygen.

3. Process according to Claim 1 or 2, **characterized in that** the pretreatment step (a) is carried out at a temperature below 300°C, preferably at room temperature.

4. Process according to any one of Claims 1 to 3, **characterized in that** the growth step (b) is carried out at a temperature below 300°C, preferably at room temperature.

5. Process according to any one of Claims 1 to 4, **characterized in that** the substrate capable of being nitrided consists of a semi-conductor material, a conductive material or a polymer having polar groups.

6. Process according to Claim 5, **characterized in that** the substrate is selected from silicon, silicon oxide (SiO₂), germanium/silicon mixtures GeₓSi₁₋ₓ in which 0<x≤1, titanium, tungsten, aluminium and copper.

7. Process according to Claim 6, **characterized in that** the substrate is silicon or silicon oxide, and the barrier layer is a layer of silicon nitride Si₃N₄.

8. Process according to Claim 7, **characterized in that** the Ta₂O₅ dielectric layer constitutes the dielectric layer of a transistor gate, of a nonvolatile memory structure, of a capacitor of a DRAM memory, or of a decoupling or filtering capacitor of an integrated circuit.
